Europäisches Patentamt

European Patent Office

Office européen des brevets

(19)

(11) Publication number: **0 185 998**

**A1**

(12) # EUROPEAN PATENT APPLICATION

(21) Application number: **85115467.4**

(22) Date of filing: **05.12.85**

(51) Int. Cl.⁴: **H 05 K 3/44**
**C 23 C 10/00**

(30) Priority: **14.12.84 US 681935**

(43) Date of publication of application:
**02.07.86 Bulletin 86/27**

(84) Designated Contracting States:
**AT BE CH DE FR GB IT LI LU NL SE**

(71) Applicant: **DYNAMICS RESEARCH CORPORATION**
**60 Concord Street**
**Wilmington Massachusetts 01887(US)**

(72) Inventor: **Bakewell, Joseph J.**
**178 Georgetown Road**
**Boxford, Mass. 01921(US)**

(74) Representative: **EGLI-EUROPEAN PATENT ATTORNEYS**
**Horneggstrasse 4**
**CH-8008 Zürich(CH)**

(54) **Interconnection circuits made from transfer electroforming.**

(57) An interconnection circuit of unusually fine definition is made in a pollution-free liftoff process using either a rigid mandrel and a flexible substrate onto which the pattern is transferred or a flexible mandrel and a rigid substrate onto which the pattern is transferred. The overplated pattern on the mandrel need have no necessary interconnection border to permit removal thereof from the mandrel. In one embodiment the mandrel is made of glass from which an electroformed pattern is lifted. In this embodiment a permanent metalized pattern on the glass is interspersed with dielectric islands of material, and the liftoff is accomplished by providing an adhesive-coated flexible substrate, such as Kapton, which is pressed over the pattern such that only the overplated pattern is lifted off. While the foregoing utilizes a transparent nonconductive mandrel which includes an overlying transparent conductive layer, less highly defined circuits may be manufactured in the same liftoff manner through the utilization of a conductive mandrel in which the exposed portion of the conductive mandrel forms the appropriate metalized pattern, with dielectric material selectively formed on the mandrel in between the exposed metal. The formation of dielectric islands increases resolution in both the nonconductive and conductive mandrel embodiments and permits the use of a wide variety of metals in the patterning so that metal deposited on metal may be easily lifted off by the adhesive-coated substrate while maintaining fine definition.

*Conductive Mandrel Process*

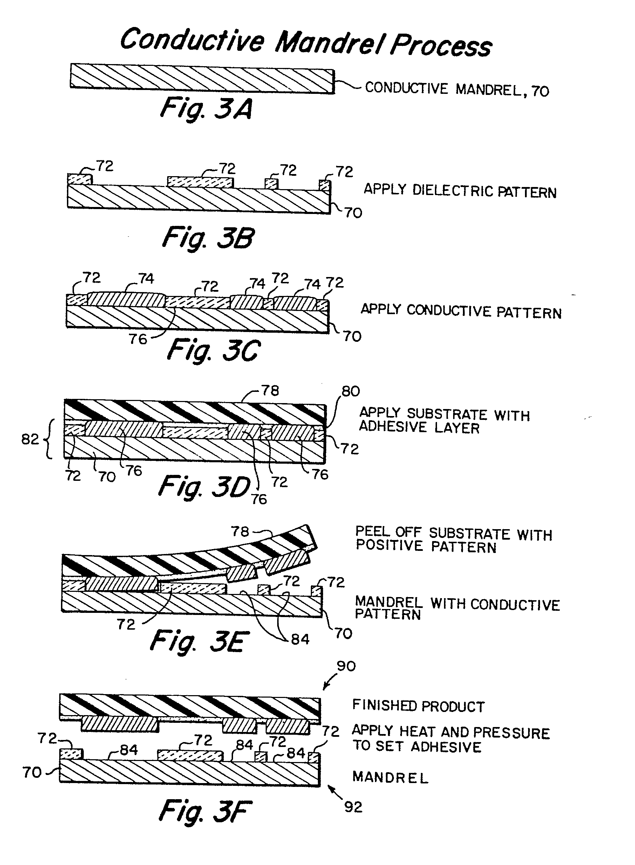

*Fig. 3A* — CONDUCTIVE MANDREL, 70

*Fig. 3B* — APPLY DIELECTRIC PATTERN

*Fig. 3C* — APPLY CONDUCTIVE PATTERN

*Fig. 3D* — APPLY SUBSTRATE WITH ADHESIVE LAYER

*Fig. 3E* — PEEL OFF SUBSTRATE WITH POSITIVE PATTERN; MANDREL WITH CONDUCTIVE PATTERN

*Fig. 3F* — FINISHED PRODUCT; APPLY HEAT AND PRESSURE TO SET ADHESIVE; MANDREL

## FIELD OF INVENTION

This invention relates to the formation of circuits by flexible liftoff and, more particularly, to the formation of circuit patterns which require no physical interconnection in order to be transferred to a flexible or other substrate.

## BACKGROUND OF THE INVENTION

As illustrated in U.S. Patent 3,703,450 to J. J. Bakewell entitled Method of Making Precision Conductive Mesh Patterns and assigned to the Assignee hereof, a process is described for the making of an extremely precise conductive mesh on a noncconductive glass substrate which is provided with a pattern corresponding to the mesh via photolithography or other technology. The entire structure is overcoated with a photoresist material, and the entire structure is irradiated with light from the bottom. The photoresist material is then developed and exists on top of the patterned metalized areas whereupon a dielectric is formed over the top of the entire structure. The photoresist is then dissolved and the dielectric material is simultaneously removed from over top of the developed photoresist during the developing process. This leaves the original metal pattern with dielectric to either side. The pattern with dielectric material in between is then overplated with metal such that a relatively thick wire mesh is formed in between the dielectric material, with edges which are contiguous such that the wire mesh may be lifted from the mandrel by lifting an edge. It will be appreciated that in a wire mesh all of the mesh portions are interconnected one to the other such that the liftoff may be easily accomplished through the lifting off of one edge of the pattern. In this patent the mesh is self-supporting and is utilized by itself for purposes other than in electronic circuits.

It will however be appreciated that electronic circuits require freestanding isolated interconnection buses or interconnects in the form of patterns that are not connected together or to an edge and that the aforementioned Bakewell process by itself is not generally applicable to fabricating the isolated patterns associated with printed circuits.

Moreover, there is a need for increasing line density in printed circuit boards which is not achievable by conventional circuit board patterning techniques. Silkscreen resist patterns on copper laminated printed circuit boards or photoresist patterns on these boards followed by etching yield lines in the 3 to 10 mil range.

Additive processes utilizing electroplating can be used to form circuits on flexible or rigid substrates with fine lines, i.e., line densities of 10,000 lines per inch. However, photoresist patterns must be fabricated for each and every circuit which involves a costly repetitive patterning process.

By way of further background, referring to U.S. Patent 3,729,388 issued to DeAngelo et al, a liftoff system is illustrated in which conductive metal such as copper is lifted off of a valve metal. This technique does not provide a reusable patterned mandrel because the pattern is lifted off, necessitating repatterning of the metal onto the mandrel each time. Moreover, this technique does not yield the required line density for present-day printed circuit board applications. Importantly, the DeAngelo et al patent works only for a preselected small number of metals and utilizes a conductive mandrel. In the DeAngelo et al patent, suitable valve metals are selected from the group consisting of tantalum, niobium, molybdenum and tungsten. With the pattern being deposited on a valve metal base through electroless plating, the subsequently formed discrete conductive patterns are said to have poor adhesion to the valve metal base and therefore can be removed rather easily by manual removal in terms of being lifted from the valve metal base. However, in this patent dielectric material is not interspersed between the pattern lines and thus pattern definition is severely limited. The absence of dielectric material also dictates repatterning for every use.

It will be noted that in the DeAngelo et al patent, a suitable substrate or background support is utilized to remove the plated-up patterns, the substrate being provided with a tacky or sticky adhesive so that the pattern formed may be lifted off. According to this patent, the process utilized here defines a grid which may be utilized in print circuit board configurations. The surprising result according to this patent was to find that one could metal plate a conductive form or pattern, e.g., copper, in contact with a valve metal without having electrodeposition upon the valve metal. In this manner it is said that copper is selectively electroplated only upon discrete patterns and not upon the valve metal cathode base. DeAngelo et al gives as the reason for this that tantalum or niobium has a naturally-occurring oxide film which covers the surface areas, with the naturally-occurring oxide film said to range from 5 to 20 Angstroms in thickness. The hypothesis is that this oxide film passivates the base thereby preventing it from becoming plated while functioning as the cathode during electrodeposition. It is said therefore that the particular valve metal base employed as cathode requires a particular plating bath selected so that it will not attack this oxide coating and thereby lead to deposition on the cathodically charged base. Thus the DeAngelo process is limited to carefully selected metals and critical processing techniques.

Aside from the limited numbers of metals that can be used, another problem with the type of process described in the DeAngelo et al patent is pattern definition which is extremely poor due to the lack of any dielectric material between the pattern edges. Building up of metals on other metals without constrictions of dielectric materials produces extremely nonuniform electroformed coatings since the electroformed material spills out over the side of the pattern onto the mandrel which can sometimes cause shorting or the inability to preserve ultranarrow line widths or spacings. Thus the line definition achievable by DeAngelo et al is not commensurate with the requirements of today's printed circuit technology.

In summary, there is no dielectric between the pattern lines on the DeAngelo master so that the selective plating is critically dependent on the conductive mandrel material and the particular metal used. Most importantly, the stripping of the pattern from the mandrel completely removes the pattern such that the mandrel is not reusable.

Other patents which describe electroforming processes for providing integrated circuits include U.S. Patents 3,402,110; 4,039,397; 2,692,190; 3,181,986; 4,159,222; 4,306,925 and British Patent 1,116,299, published June 6, 1968.

It should be noted that in U.S. Patent 3,402,110 the final pattern is not lifted off and bonded to a substrate and requires an outside frame to be formed. In short, in this patent a metal stencil is formed and can be only used to make a sheet having metal with holes, thereby precluding the possibility of having freestanding isolated circuits.

Perhaps, more importantly, the large majority of the prior processes, since they do not use reusable mandrels, require some auxiliary processing of the mandrel each time, which requires large volumes of toxic materials as photoresists, developers and other solvents. This leads to hazardous waste disposal problems.

## SUMMARY OF THE INVENTION

It is therefore one of the objects of the subject invention to provide a pollution-free reusable mandrel with dielectric material interposed between a permanent conductive pattern on the mandrel, such that upon liftoff of an overplated pattern, the overplated pattern is provided with the required line accuracy and definition while at the same time permitting the utilization of a discontinuous pattern which need not be joined at the edges in order to be electroformed or lifted off the mandrel.

In order to provide for a line density of 10,000 lines per inch, in one embodiment a nonconductive mandrel process is utilized in which the mandrel is transparent and is provided with a transparent conductive coating to permit the electroforming of a permanent metal pattern interspersed with dielectric islands. The use of glass permits patterning to a degree not possible through the utilization of conductive mandrel patterning and therefore provides a unique reusable mandrel capable of producing ultrafine line interconnects for present-day circuits. Alternatively, a conductive mandrel is used when line definition is not critical.

In either case, the permanent pattern is overplated with a different metal or, if the same metal is used, the permanent metal pattern is passivated, naturally or otherwise. In either case this permits removal of only the overplated metal during the liftoff process. Thus in this process the liftoff step leaves the permanent pattern in place on the mandrel with the pattern being defined by the interspersed islands of dielectric material. For the conductive mandrel case it is the exposed portion of the conductive mandrel which forms the appropriate metalized pattern interspersed with dielectric material. In the nonconductive mandrel case, there remains a patterned metal layer which is permanently affixed to the mandrel. In this case the pattern is formed by virtue of the patterning of the dielectric over top of a transparent conductive layer.

In one step in making either type mandrel, dielectric material is deposited over a mandrel having a patterned metal surface over which a photoresist layer is patterned so that the photoresist lies only over top the metal pattern. The dielectric material is removed only above the metal patterns to leave it between the pattern lines through the utilization of a stripping process in which the stripper, usually acetone, penetrates the relatively thin top surface of the dielectric immediately above the photoresist layer, such that the stripper attacks the photoresist layer dissolving it and expanding it upwardly so as to break through the relatively thin dielectric layer immediately thereabove to expose the permanent metal pattern. This same process works also for thin metal layers atop a patterned photoresist such that extremely fine line definitions are achieved despite the fact that the photoresist material is buried beneath the material to be removed.

Fine line circuit resolutions can exceed 10,000 lines per inch in the nonconductive mandrel case, whereas line definition for the conductive mandrel case is on the order of 1,000 lines per inch which exceeds that attainable by current etching techniques.

Thus the subject process can provide interconnects or buses with a 10,000 line per inch resolution, with thicker conductors than heretofore possible at these resolutions. The circuits can be made with no waste in the procedure in which no solvents are utilized and in which there are no hot corrosive materials, no acids and no fumes involved once a permanent mandrel has been made.

The difference between the utilization of the subject mandrel and the mandrel of the aforementioned DeAngelo et al patent is that the DeAngelo et al patent applies to a narrow group of metals which precludes plating patterns on a conductive platen by electroplating processes due to a lack of dielectric material in the areas not occupied by the metalized pattern. The present use of the dielectric permits a wide variety of materials to be utilized with better definition. More importantly, the DeAngelo et al mandrel is not reusable whereas the present mandrel is reusable.

Note that the dielectric material utilized prevents the electroformed patterns from growing sidewise while they are growing thicker. For the nonconductive embodiment, in order to adapt the former Bakewell process to the present liftoff process, the transparent substrate, e.g., glass, is provided with a partially transparent conductive layer. This is necessary so that highly defined circuit lines can be electroformed. The partially transparent conductive layer also permits photoresist exposure from the bottom of the substrate. Thus the circuit pattern is formed on the mandrel with the use of an opaque conductive pattern and a photoresist on top of the pattern to permit the creation of dielectric islands in between the circuit lines by a photoresist technique in which the photoresist is exposed from the bottom of the glass mandrel and through the transparent conductive layer. The end result is the fabrication of a mandrel in the same fashion as the aforementioned electroformed mesh except that a continuous layer of semitransparent conductive material has been added to the surface of the original substrate. Moreover, another difference is that with the subject technique the circuit pattern is lifted off the original mandrel by use of an adhesive-coated substrate, usually a sheet of Kapton. This preserves the isolated pattern segments without the use of an outer frame.

It is important to note that the permanent reusable mandrel may be flexible through the use of such materials as thin glass, plastic, Kapton or nylon, thereby allowing direct transfer to a rigid substrate. A glass-to-glass or glass-to-ceramic transfer can thereby be achieved.

In summary a process is described whereby circuit patterns can be electroformed on a permanent reusable mandrel and then transferred and bonded to a flexible substrate. As an alternative, the subject circuit is manufactured by removing the circuit pattern from the mandrel by adhering it to a temporary carrier and then bonding it to a flexible or rigid substrate. The temporary carrier

is then removed and the circuit is finished through the utilization of heat and pressure to adhere the circuit to the substrate.


## BRIEF DESCRIPTION OF THE DRAWINGS


These and other features of the subject invention will be better understood in connection with the detailed description taken in conjunction with the drawings of which:

Fig. 1 is a diagrammatic illustration of a finished printed circuit board illustrating the isolated interconnect circuits formed on top of a substrate by the subject process;

Figs. 2A-2N are cross-sectional diagrams illustrating the process steps for making the integrated circuit product through the utilization of a nonconductive mandrel; and

Figs. 3A-3F are cross-sectional diagrams illustrating the process steps for making the integrated circuit product through the utilization of a conductive mandrel.


## DETAILED DESCRIPTION


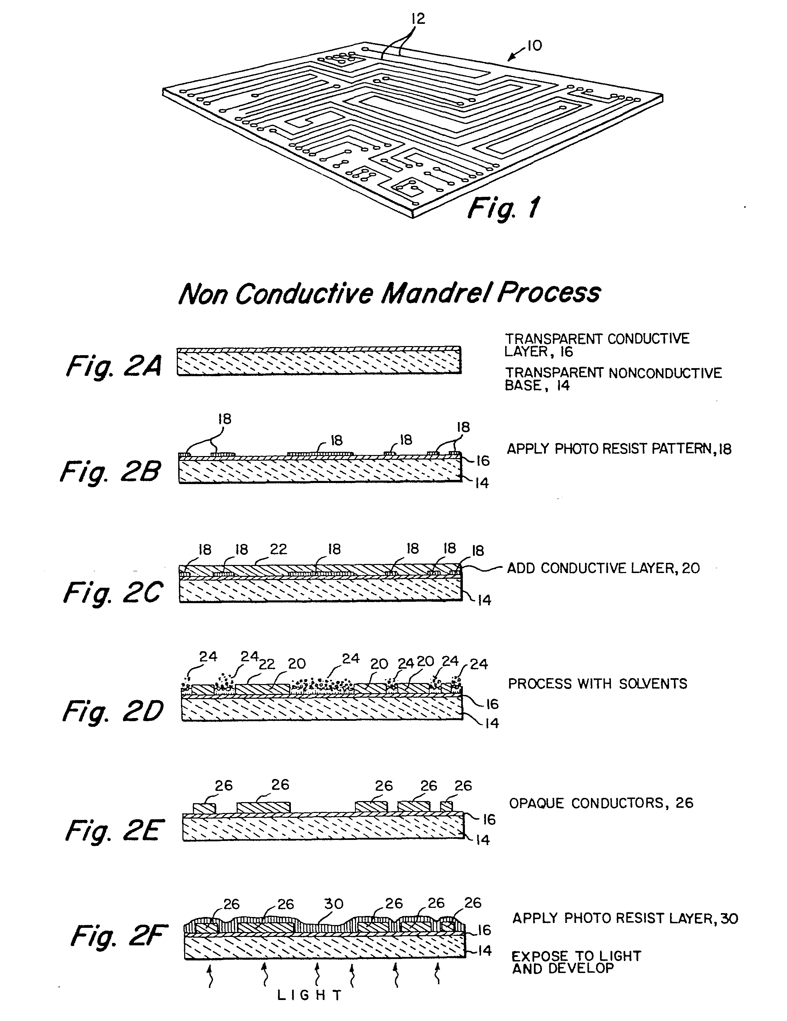

In order to obtain a printed circuit pattern on a substrate, and referring now to Fig. 1, a substrate generally indicated by reference character 10 is provided with a pattern of lines 12 thereon. It will be appreciated that the pattern has isolated portions and that there is no connection of the isolated patterns to an exterior frame or ring about the pattern. In one embodiment, substrate 10 is made of Kapton, which is a flexible material common with the so-called "flexprint" processes. As described above with a line resolution of 10,000 lines per inch, it is possible to provide by the subject process integrated circuit patterns on such substrates which are exceedingly fine indeed, thereby contributing to the circuit density achievable by the interconnection circuit board.

As described hereinbefore, the discontinuous pattern is provided in a liftoff process through either the use of a nonconductive mandrel with a permanent pattern of metalization thereon interspersed with dielectric islands or through the use of a conductive mandrel in which the pattern is established by the dielectric islands, the surface of the mandrel providing a conductive surface over which to overplate the pattern to be lifted off. In either process, the mandrel is reusable in the sense that it may be used over and over again after the electroplated material is lifted off the mandrel. The permanent conductive pattern is said to be permanent in the sense that it is not lifted off or destroyed during the liftoff of the overplated metal.

### Nonconductive Mandrel Process

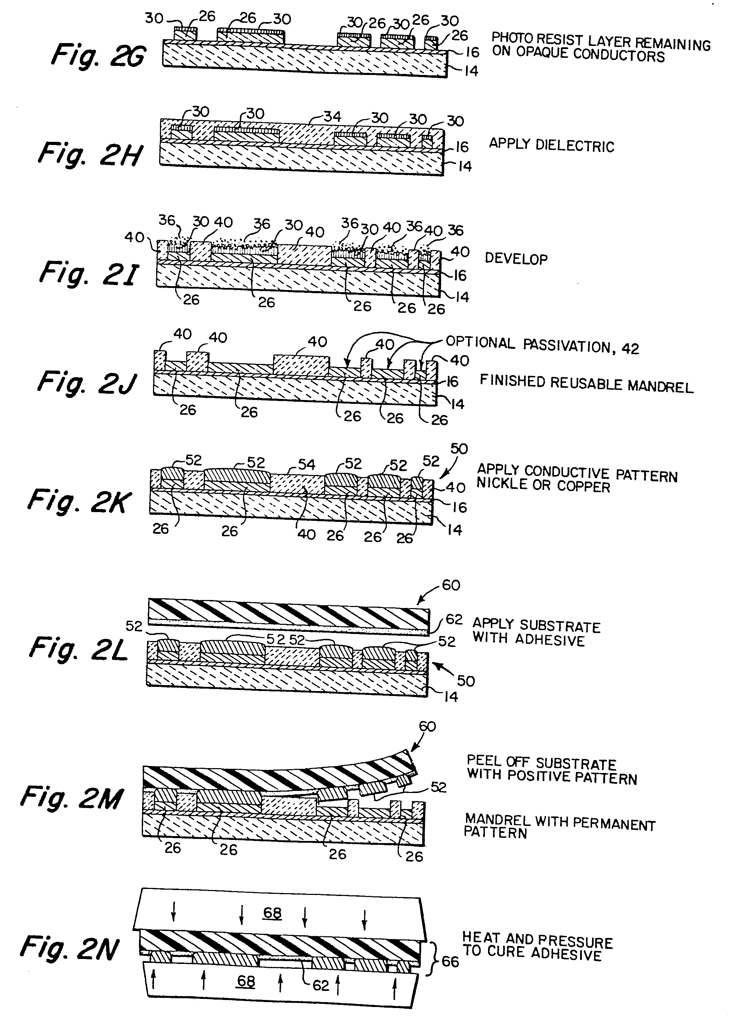

Referring to Fig. 2A, a transparent nonconductive base 14, which may be glass or plastic, is covered with a partially transparent conductive layer 16 which may be evaporated chromium and gold manufactured by MRC of Orangeburg, New York. In Fig. 2B layer 16 is provided with a patterned photoresist 18, which in turn, as illustrated in Fig. 2C, is provided with a conductive layer 20 which may be an evaporated deposition or a sputtered deposition.

As illustrated in Fig. 2D, photoresist 18 is dissolved or stripped through the processing with solvents, such as acetone, which removes not only the photoresist layer which expands through contact with the solvents which enter through the top surface 22 of the metal layer but also removes the portion of metal layer 20 which overlies the photoresist. The removal is illustrated by the granular structure 24 such that, as illustrated in Fig. 2E, opaque conductors 26 remain on top of conductive transparent layer 16. The solvents enter through the top surface and diffuse down to remove the photoresist and the overlying metal layer without attacking those portions of conductive layer 20 which lie on transparent conductive layer 16. The resolution obtainable through this process is commensurate with the aforementioned 10,000 line per inch resolution.

The mandrel is further prepared by the application of a photoresist layer 30 over the structure of Fig. 2E such that the structure of 2F is formed. The photoresist layer may be of the type manufactured by American Heochst, Model No. AZ 1350 and is supplied by Shipley Company, Newton, Massachusetts. It will be noted that the sections of the photoresist over opaque conductors 26 are relatively thin, on the order of .0003 inch, in one embodiment.

As seen in the step illustrated in Fig. 2F, the structure is irradiated with light from the bottom such that, upon development, the structure of Fig. 2G remains. This includes base 14, transparent conductive layer 16, opaque conductors 26 and photoresist 30.

It will be appreciated that the photoresist has the same resolution as the high resolution conductors previously formed on the transparent substrate. Thereafter a dielectric layer 34 is applied over the entire surface of the structure of Fig. 2G to achieve the structure of Fig. 2H, with the dielectric material in one embodiment being silicon monoxide manufactured by MRC, Orangeburg, New York, Model No. 30-202A S1504-400, having a thickness of .0002, which is applied by vacuum evaporation.

Referring now to Fig. 2I, photoresist 30 is dissolved or stripped again with such solvents as acetone such that the photoresist is dissolved, expands and breaks up and granularizes as illustrated at 36 leaving dielectric islands 40 interspersed between permanent conductors 26.

The resulting structure is as illustrated in Fig. 2J in which a finished reusable mandrel includes the dielectric islands 40 significantly raised above permanent metalized pattern conductors 26 which rest upon conductive layer 16 which lies on substrate 14. In one embodiment the tops of the islands lie .0003 inch above the tops of conductors 26 so that the lifted off metal pattern has a thickness in excess of .0003 inch.

Depending upon the overplated layers which are to form the pattern metalization for the final product, an optional passivation step may provide, for instance, an oxide passivation coating 42 on the top surfaces of conductors 26. However, in the usual case there is a sufficient amount of contaminating oxide or material on the top surface of conductors 26 so that no special effort need be made to passivate the top portions of these conductors. In fact, especially with gold, chromium and copper, such a layer is formed naturally under ambient conditions. Note that, were it desirable to adhere an overplated layer to these conductors, special processing in terms of cleaning and abraiding is usually necessary. However, in the present process such cleaning processes are avoided because it is the purpose of the subsequent overplatings step to provide a liftable pattern from these permanent metalized areas on the transparent substrate.

In order to utilize the mandrel, and referring now to Fig. 2K, the mandrel structure formed in 2J, here illustrated generally by reference character 50, is overplated with metal as illustrated at 52 to a level of .0003 inch in one embodiment, with the metal layer extending slightly above the top surface 54 of dielectric layer 40. It will be appreciated that the thickness of the dielectric layer in part determines the thickness of the layer to be lifted off, with the remainder of this thickness being determined by the thickness of the permanent conductors 26. In the usual case, the overplated layers are of nickel or copper which will extend slightly over the dielectric material. It is therefore the definition of the dielectric material which is in turn responsive to the patterning resolution of the permanent conductors which yields a pattern of liftable conductors having a resolution commensurate with those of the permanent conductors. While nickel or copper is the preferred liftoff metalization, gold or silver or indeed any other metal which is platable over the permanent conductors may be utilized. It will be appreciated that the plating process can take place due to the existence of conductive layer 16 since substrate 14 is nonconductive.

The next step in the process of forming the pattern on a substrate, as illustrated in Fig. 2L, a flexible substrate 60, in one embodiment Kapton, is provided with an adhesive layer 62. The combined structure is pressed down over structure 50 such that the top surfaces of the overplated conductive layers 52 extend into the adhesive layer. This process may require mild heating to make the adhesive layer sticky. The adhesive may, in one embodiment, be Dupont LF Pyraulux, although other adhesives may be utilized. Alternatively substrate 60 may be rigid whereas the mandrel substrate 14 may be made sufficiently flexible such that the liftoff process illustrated in Fig. 2M can occur. Assuming that a flexible substrate 60 is utilized, as can be seen, the overplated conductive pattern 52 is lifted off of the permanent conductors 26 to leave the mandrel with the permanent pattern such as illustrated in Fig. 2J.

If desired and as illustrated in Fig. 2N, heat and pressure may be applied to the structure generally indicated by reference character 66 via platens 68 or rollers (not shown) to cure adhesive layer 62 for providing a structurally sound finished product such as that illustrated in Fig. 1.

The utilization of a glass substrate for this process, along with the utilization of a semitransparent conductive layer such as chromium, permits resolution considerably higher than that associated with conventional printed circuit board patterning techniques. This in turn provides increased line density for the finished product through the utilization of the subject high resolution reusable mandrel.

Moreover due to the utilization of dielectric material islands between the permanent conductors, relatively thick patterns may be transferred by the peel-off or liftoff process of Figs. 2L and 2M, thereby to improve the current carrying capacity of the integrated circuit patterns produced in this manner.

### Conductive Mandrel Process

While 10,000 lines to the inch resolution may be desirable in some cases, resolutions of 1,000 lines per inch may be provided through a conductive mandrel process illustrated in Figs. 3A-3F. In this process a conductive mandrel 70, which may be made of stainless steel, chromium-plated copper, nickel or chromium-plated ceramic, is provided with a patterned dielectric 72 in any conventional manner, such as by silkscreening, photoresist, stencilling or laminating. As illustrated in Fig. 3C conductive overplated material 74 is provided in the spaces between the dielectric islands 72. Overplated material 74 is lifted off of the conductive mandrel through the processes illustrated in Figs. 3D and 3E. As before, the conductive material to be lifted off may be the same as that of the substrate assuming some type of natural process passivation so that the overplate material can in fact be removed from the top surface 76 of mandrel 70. different materials are utilized vis-a-vis liftoff layer and the mandrel, then special passivation is usually necessary.

As illustrated in Fig. 3D, a flexible substrate 78 with an adhesive layer 80 of the type described hereinbefore is pressed down on the structure generally indicated by reference character 82 to include conductive mandrel 70, overplated material in the form of conductors 76 and dielectric islands 72, with the dielectric islands being of a material which is not easily removed from the conductive mandrel. Such islands in one embodiment consist of cured epoxy with the mandrel material being 316 stainless steel.

The peel-off process is as described before as illustrated in Fig. 3E, leaving the mandrel with a conductive pattern established by surfaces 84 of mandrel 72 between dielectric islands 72.

As illustrated in Fig. 3F, the finished product, here illustrated by reference character 90, may be heat and pressure set, whereas the reusable mandrel here illustrated by reference character 92 is shown to be identical to that of Fig. 3B in which the conductive mandrel 70 has dielectric islands 72 which define a conductive pattern in the spaces therebetween on surface 84 of mandrel 70.

The use of a transparent non-conductive base such as glass allows the fabrication of multilayer circuits to be made in which the second and subsequent layers are very accurately positioned relative to the preceeding layer(s). This is accomplished by optical registration viewing the respective layers through the transparent non-conductive base. Such critical registration of layers is of importance for fine line very dense circuitry.

Having above indicated a preferred embodiment of the present invention, it will occur to those skilled in the art that modification and alternative can be practiced within the spirit of the invention. It is accordingly intended to define the scope of the invention only as indicated in the following claims:

- 16 -

0185998

C L A I M S

What is claimed is:

1.    A method of providing patterned interconnections on an insulating substrate with a reusable mandrel comprising:

providing a pattern of liftable metal having isolated disconnected pattern parts on a permanent mandrel having a corresponding nonliftable electrically-conductive pattern thereon, with a nonliftable patterned dielectric material on the mandrel in between the liftable metal pattern; and

pressing an adhesive-bearing substrate over said liftable metal pattern such that the adhesive contacts said liftable metal pattern and such that said liftable metal pattern is transferred to said substrate without the aid of any necessary interconnection between isolated disconnected pattern parts and whereby said patterned dielectric material provides improved definition of the pattern transferred.

2.    The method of claim 1 wherein said substrate is flexible and said mandrel is rigid.

3.    The method of claim 1 wherein said mandrel is flexible and said substrate is rigid.

4.    The method of claim 1 wherein said liftable metal pattern is electroformed on top of said nonliftable electrically-conductive pattern.

0185998

5.    The method of claim 1 wherein said mandrel is glass having a semitransparent conductive layer thereon on which said nonliftable pattern is formed, thereby to permit the formation of fine definition liftable patterns.

6.    The method of claim 1 wherein said mandrel is metal.

7.    The method of claim 1 wherein said nonliftable pattern includes metals taken from the group consisting of gold, chromium and copper.

8.    The method of claim 1 wherein said nonliftable pattern is passivated prior to electroforming the liftable pattern thereon.

9.    The method of claim 1 wherein said liftable pattern is taken from the group consisting of nickel, copper, gold and silver.

10.    The method of claim 1 wherein said adhesive-bearing substrate is a temporary substrate.

11.    The method of claim 10 wherein the pattern on said temporary substrate is lifted from said temporary substrate onto a permanent substrate.

12.    The method of claim 1 and further including the step of curing the adhesive on said adhesive-bearing substrate after liftoff of said liftable pattern.

13.    The method of claim 1 and further including the step of curing the pattern on said adhesive-bearing substrate after liftoff of said liftable metal pattern, including the utilization of pressure during the curing process.

14.   The method of claim 1 wherein said liftable metal pattern is built up to a level above the top of said dielectric patterned material.

15.   A product made by the method of claim 1.

0185998

*Fig. 1*

## Non Conductive Mandrel Process

*Fig. 2A*

TRANSPARENT CONDUCTIVE LAYER, 16

TRANSPARENT NONCONDUCTIVE BASE, 14

*Fig. 2B*

APPLY PHOTO RESIST PATTERN, 18

*Fig. 2C*

ADD CONDUCTIVE LAYER, 20

*Fig. 2D*

PROCESS WITH SOLVENTS

*Fig. 2E*

OPAQUE CONDUCTORS, 26

*Fig. 2F*

APPLY PHOTO RESIST LAYER, 30

EXPOSE TO LIGHT AND DEVELOP

LIGHT

0185998

**Fig. 2G** — PHOTO RESIST LAYER REMAINING ON OPAQUE CONDUCTORS

**Fig. 2H** — APPLY DIELECTRIC

**Fig. 2I** — DEVELOP

**Fig. 2J** — OPTIONAL PASSIVATION, 42 / FINISHED REUSABLE MANDREL

**Fig. 2K** — APPLY CONDUCTIVE PATTERN NICKLE OR COPPER

**Fig. 2L** — APPLY SUBSTRATE WITH ADHESIVE

**Fig. 2M** — PEEL OFF SUBSTRATE WITH POSITIVE PATTERN / MANDREL WITH PERMANENT PATTERN

**Fig. 2N** — HEAT AND PRESSURE TO CURE ADHESIVE

## Conductive Mandrel Process

CONDUCTIVE MANDREL, 70

*Fig. 3A*

72  72  72  72

APPLY DIELECTRIC PATTERN

70

*Fig. 3B*

72  74  72  74 72  74 72

APPLY CONDUCTIVE PATTERN

76  70

*Fig. 3C*

78  80

APPLY SUBSTRATE WITH ADHESIVE LAYER

82

72  70  76  72  72  76  76

*Fig. 3D*

PEEL OFF SUBSTRATE WITH POSITIVE PATTERN

78

72  72

MANDREL WITH CONDUCTIVE PATTERN

72  84  70

*Fig. 3E*

90

FINISHED PRODUCT

APPLY HEAT AND PRESSURE TO SET ADHESIVE

72  72  72

72  84  72  84  84

70  84

MANDREL

*Fig. 3F*  92

## EUROPEAN SEARCH REPORT

European Patent Office

| | DOCUMENTS CONSIDERED TO BE RELEVANT | EP 85115467.4 | |
|---|---|---|---|

| Category | Citation of document with indication, where appropriate, of relevant passages | Relevant to claim | CLASSIFICATION OF THE APPLICATION (Int Cl 4) |
|---|---|---|---|
| A | EP - A2 - 0 121 391 (NITTO) <br> * Abstract; fig. 3; claims 1-5 * <br> -- | 1-5 | H 05 K 3/44 <br><br> C 23 C 10/00 |
| A | US - A - 3 873 361 (FRANCO) <br> * Abstract; fig. 1 * <br> -- | 1 | |
| A | GB - A - 2 082 632 (GEC) <br> * Fig. 1-3; claims 1-28; abstract * <br> -- | 1,7,9 | |
| A | GB - A - 1 559 468 (NITRO NOBEL) <br> * Fig. 1-7; claims 1-17 * <br> -- | 1,7,9, 15 | |
| A | EP - A1 - 0 089 604 (IBM) <br> * Fig. 1-5; claims 1-17 * <br> -- | 1,7,9 | TECHNICAL FIELDS SEARCHED (Int Cl 4) |
| D,A | US - A - 3 703 450 (BAKEWELL) <br> * Abstract; fig. 1-8 * <br> ---- | 1 | H 05 K 1/00 <br> H 05 K 3/00 <br> C 23 C 10/00 |

The present search report has been drawn up for all claims

| Place of search | Date of completion of the search | Examiner |
|---|---|---|
| VIENNA | 20-03-1986 | VAKIL |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82